Europäisches Patentamt

European Patent Office

Office européen des brevets

(19)

(11) Publication number: **0 330 763**
**A1**

## (12) EUROPEAN PATENT APPLICATION

(21) Application number: 88200406.2

(22) Date of filing: 03.03.88

(51) Int. Cl.⁴: **H01J 37/304** , **H01J 37/26**

(43) Date of publication of application:
06.09.89 Bulletin 89/36

(84) Designated Contracting States:
CH DE FR GB LI NL

(71) Applicant: **N.V. Philips' Gloeilampenfabrieken**
**Groenewoudseweg 1**
**NL-5621 BA Eindhoven(NL)**

(72) Inventor: **Roelofs, Bernardus Johannes G.M.**
**c/o INT. OCTROOIBUREAU B.V. Prof.**
**Holstlaan 6**
**NL-5656 AA Eindhoven(NL)**
Inventor: **Meuwissen, Antonius Marie**
**c/o INT. OCTROOIBUREAU B.V. Prof.**
**Holstlaan 6**
**NL-5656 AA Eindhoven(NL)**

(74) Representative: **Scheele, Edial François et al**
**INTERNATIONAAL OCTROOIBUREAU B.V.**
**Prof. Holstlaan 6**
**NL-5656 AA Eindhoven(NL)**

(54) Charged particle apparatus with automatic beam set-up.

(57) A charged particle apparatus is provided with means for measuring beam currents dependent on scanning settings for the particle beam. From these measurings data can be obtained from which signals can be derived for setting optimal feedings for relevant charged particle optical elements of the apparatus.

EP 0 330 763 A1

## Charged particle apparatus with automatic beam set-up

This invention relates to an electron or ion beam apparatus provided with a particle source, a charged particle optical system, an object carrier and current measuring means.

Such an apparatus in the form of an electron beam inspection apparatus is known from EP 196.958.

When use is made of this kind of apparatus, normally having a gaussian beam cross section current distribution the highest brightness of the source should be used in order to improve the throughput for a given definition, such as indicated in IEEE Journ. of S St. Cire, Vol. 8c15 No. 4, Aug. 1980 pp. of J.C. Wolfe. It is therefore desirable to use for example sharp-tip cathodes such as for LaB6. Due to a non-homogeneous emission pattern over the emitting surface of such a cathode optimization of relevant parameters is difficult. An optimalization of the set-up is very desirable because any spot current variations results directly in a mis-measuring for detecting an analyzing apparatus and in a mis-writing in pattern generators or implatation apparatus.

Usually direct observation of the source is not possible in these production machines. The only means which give an insight into the optical column are emission current, beam current, spot characteristics and settings of alignment coils and lenses. Moreover, when only one aligment unit is used with several lenses, several local optima can exist in the alignment. As a result, the optimum of these non-orthogonal parameters is difficult to obtain, even for a skilled operator. Many apparatus avoid these difficulties by using a flat-tipped cathode, but at the penalty of lower brightness.

A direct observation of the source and particle beam throughout the whole column of such apparatus is often not possible. The different elements of such a system have to be adjusted by interpretation of the dynamic effects generated thereby on the parameters which can be measured at the substrate plane, like beam current, spotsize and position. In such a multi-element system the parameters to be optimised are not orthogonal, so the absolute optimisation is very difficult to achieve by hand due to the many local optima and is therefor a suitable subject for automization.

It is an object of the invention to provide a charged beam particle apparatus provided with means to obtain measuring data obtainable from the apparatus and means to calculate control signals from these data to be used for setting the feeding of relevant charged particle optical elements of the apparatus.

In practice two major principles are useful for an auotmatic column set-up according to the invention to wit:
- a non-uniformity in the angular distribution of the emission current can be used for the alignment of the column and
-well defined planes related to the position of the electron optical elements give a reliable figure about demagnification and source size and hence the required spot size.

Therefore software has been developed to achieve the optimum setting automatically using the knowledge of the dynamic behaviour of the different parameters to limit the multi dimensional space in which these parameters have to be optimized. This limitation is necessary because a search through all possible settings would require an unacceptable amount of machine time.

The software adjusts the cathode temperature, according to the specified brightness (while never overheating the tip), selects the correct part of the beam and sets the required spotsize. The optimization time is dominated by physics and electronics and not by required spotsize. The optimization time is dominated by physics and electronics and not by the algorithms. The adjustment time of the tip temperature is determined mainly by the heat capacitance of the complete cathode assembly mounting; the time to find the correct lobe and alignment is determined by the time constant of the alignment coils and drivers and the spotsize setting by the time constants of lenses and drivers.

The software is split into modules which handle the parameters with different time dependence separately. For example, the stability of lens characteristics are only dependent on the stability of acceleration voltage and the driver current. Therefore if once a table with demagnification factors has been made, this stable needs only an update if the calibrated values of the high voltage or lens current supplies are charged.

This approach means, that the optimization time before and during writing is restricted to the time needed for setting the short term stability parameters.

The invention will be further elucidated by reference to the drawings in which,

Figure 1 shows a sketch of an electron beam writer column,

Figure 2 shows beam paths for electrons emitted from a cathode tip for different temperature,

Figure 3 a multiple beam alignment and,

Figure 4 shows images of emitting pattern from such a cathode tip

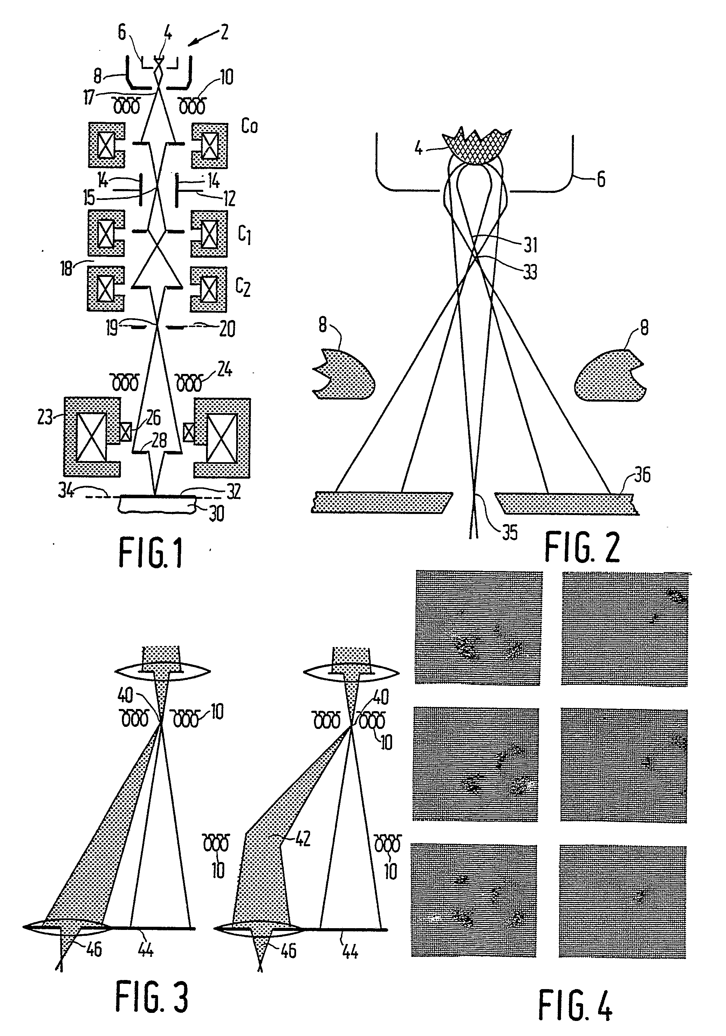

An electrode beam writer as given in Figure 1 shows:
- a triode gun 2 with a cathode 4 for example a tungsten or LaB6 cathode, a wehnelt electrode 6 and a first anode 8,
- a set of alignment coils 10 with different pivot points,
- a beam blanking system 12 with single electrostatic blanker plates 14 centred on an image 15 of a crossover 17 formed by a first lens,
- a zoom lens 18 consisting of two lenses C1 and C2 which focus, a crossover image 19 in a fixed object place 20 for a final lens independent of the demagnification,
- a stigmator 24, a fine focus lens 26 and an exchangeable aperture 28.

The system further comprises a and an object carrier 30 for positioning an object 32 in an object plane 34.

The electron source is one of the most important elements in the column as the object to be imaged on the substrate. Since the geometrical aberrations of conventional electron lenses cannot be eliminated the quality of the images can only be improved by limitation of the pupil in the lenses. However this limits the beam current and hence the throughput. A further increase of beam current can only be achieved by the application of a higher brightness gun. The brightness is a figure for the current density per solid angle and is conserved throughout aberration free electron optics. It is this figure that has to be optimized.

A triode gun as showed in Figure 2 consists an anode 8 a wehnelt 6 and cathode 4. The cathode is heated and thereby some electrons can leave the surface, if their energy exceeds the workfunction. The electric field between anode and cathode accelerates these electrons further. A negative potential on the whehnelt limits the emission current. This negative potential is the voltage drop over a resistor, through which the emission current flows.

In the figure three crossover points 31, 33 and 35 standing for different cathode temperatures are given showing a strong dependence of the beam current transpassing a diaphragm 36 here located in the plane of crossover 35.

The maximum number of electrons that can leave the surface is given by the Richardson equation, which shows a dependence only upon the temperatur and workfunction, so the maximum theoretical brightness is limited thereby. The increase in brightness by an increase in temperature has always a penalty in life of the cathode due to evaporation so only the selection of low work function materials is left, like lanthanum hexaboride.

The potential difference between cathode and wehnelt creates a lens action. At a low temperature only a few electrons can leave the surface; so the emission current will be low, the lens strength small and no crossover will be formed. This means a broad solid angle in which the electrons are emitted. Also, a large part of the cathode contributes to the emission current because the funnel of the zero-equipotential surface, in which the electrons can leave, crosses the cathode with an large enclosed area (Figure 3).

With an increase in temperature the emission current and the lens strength will increase while the zero-equipotential funnel will narrow. Eventually the restriction of the emitting area balances the increased emissivity, causing the well known knee in the graphs of emission current versus cathode temperature, the saturation point. At this temperature, the emission current is not limited by the space charge of the emitted electrons as is often erroneously thought but by the restricted emitting area and it is not a proper criterium to define the temperature of the cathode.

The stronger lens action of the wehnelt also forms a crossover in the beam; initially this crossover is positioned far from the cathode but moves towards it as the wehnelt lens becomes still stronger. At the point where the crossover is imaged in the limiting aperture, or pupil, of the column we have a peak in the beam current; on either side of this peak, interception of the diaphragm will decrease the current. At a higher temperature, the higher brightness cancels out the interception, and the transmitted current increases. At a still higher temperature the space charge will cause a decrease of the brightness by the increase of energy spread. This point coincides with the knee in the transmitted beam current. Therefore it is useless to go beyond that point though the beam current still increase a little.

With an increase of the wehnelt cathode distance the position of the knees in emission and beam current and the maximum in the brightness coincide more and more while a shift of the cathode towards the wehnelt makes the more pronounced.

When a sharp tip single crystel LaB6 cathode is used due to the different low work function areas around the tipe of the crystal a non-uniform angular emission distribution exists up to a higher temperature than in the case of a tungsten filament. In the latter case the emitting area is much larger so that the angular non-uniformity disappears at a much lower tip temperature relatively.

Another complication is the change in tip shape due to the anisotropic evaporation of the different crystal planes in vacuum conditions worse than 2. 10E-7 torr for example. A fresh tip has a pronounced center lobe while old one shows stronger side lobes due to the evaporation of the tip (although also emission in the middle is inhibited by settlement of impurities on the front end). From the same figure it is also clear that the contraction of the lobes occurs at higher temperatures for old cathodes.

At a low temperature the crossover is not single, but it contracts into a single waist at a higher temperature, so only one spot is imaged on the target plane; at this point the side lobes in the angular emission distribution still exist. The size of the waist is dominated by the spherical aberration of the wehnelt, so, due to the larger emitting angles with an old cathode, this delivers a large crossover with larger subtended solid angles and hence a lower brightness.

The temperature and alignment setting algorithms can be explained using the first order theory.

The alignment unit as shown in Figure 3 consists of 2 sets of coils 10 each set has its own pivot point, here points 40 and 42 respectively. The tilt alignment coils tilt the beam axis about the crossover position, while the position of the shift pivot point moves along the axis with the changing lens settings.

When starting up with a new filament, the first step after reaching a low emission value is to search for beam current at the target. It is better to carry out this initial search with the cathode at low temperature and the gun far from saturation to avoid overheating and having to search through both alignment functions; in the latter case the necessary four dimensional search to find the absolute optimum means a huge penalty in search time. At a low temperature and emission current the emitting angle is broad and tilt function not critical, so that beam current can be found by scanning through only the shift range over a diaphragm 44 meaning the distribution transpassing beamcurrent 46.

Once found, the beamcurrent tells more about the saturation process than the emission current, which is used only to define the starting point.

Under continuous alignment with alternating use of the tilt and shift functions the peak and the valley in the beam current are monitored as the cathode temperature is increased.

Because only one alignment unit is used with several lenses non-unique alignments of the beam exist. Of course, the best alignment will be with the beam as straight as possible and in line with the optical axes of the different elements, especially with the axes of final lens and deflection coils.

To achieve this, the beamcurrent is set in the region of the valley in the characteristic and the side lobes are used as pilot beams. When correctly aligned the contribution in beamcurrent of the side lobes should be in balance while the four-fild symmetry should be regular.

Subsequent scans through the tilt area, averaging the weighted contribution of the side lobes, converges the shift function to the setting for the best balance between the lobes, while the optimum main point of the lobes converges by alternating shift and tilt searches, resulting in the optimum for both tilt and shift.

In Figure 4 three steps in the alignment sequence are shown. The alignment was performed with an old, faceted cathode; this is more difficult to align lacking a center lobe.

Once the column is aligned, the temperature can be increased to a specified value; a proper value should be specified to avoid overheating.

If no absolute spotsize stability is required but only beamcurrent stability the temperature at the valley could be a proper choice for long life. For high brightness and stable spotsize and beamcurrent the temperature should be increased until the knee in beamcurrent has been reached. Any heating beyond that point only shortens the cathode life without any benefit.

The calibration time is dominated by the physical time constants. The setting of the cathode temperature depends strongly on the heat capacity of the type used and the required stability. LaB6 crystals cemented on a filament take ca. 2 hours to reach the minimum stability for the other adjustments, while the Vogel type mount 6, the crystal clamped between graphite blocks, requires ca. 4 hours.

The alignment time in the search for the absolute optimum is limited by the self-induction of the coils resulting in a calibration time of 7-10 min. Subsequently the optimization of this setting, e.g. to compensate drift, takes typically only 1-5 sec.

Once the gun has been set up the final spotsize results only from the crossover size, the demagnification and the aberration factors.

The automatic set up of spotsizes should therefore include accurate measurements of these parameters. However, again, the observation of the beam throughout the column is impossible without additional features like isolated apertures to measure the intercepted beam current etc.

Therefore adjustment algorithms have been developed which observe the effects of elements to be adjusted up on the beam current, spotsize and position in the target plane. With the object and image planes determined thereby the demagnification and the crossover size can be calculated.

The following phenomena can be used:
- - the transmitted beamcurrent through an aperture has a minimum at the maximum strength of the previous lenses;
- focussing in the middle of a lens makes the focussing independent of that lens;
- imaging in the back focal plane of a strong projector lens gives maximum transmitted beamcurrent through a subsequent aperture at a large distance;
-deflectors at a crossover image do not affect the position of the docussed beam in the target plane.

The focussing of the first lens in the middle of the beam blanker can be checked by changing the deflection field between the plates and from that the object plane for the zoom lens is known. Because this is a fixed position it is sufficient to know the actual corssover size in this plane for the later spot setting.

Focussing with the first lens of the zoom lens in the second defines the object plane for the final lens. In this setting all the lenses can be thought of as "thin" so the demagnification factor can be calculated easily from the known positions of image and object planes.

After an accurate measurement of spotsize, corrected for aberration and marker-edge errors, the actual crossover size can be calculated.

The heavy-metal marker edge slope can be calculated by correlation of spot measurements at different demagnification factors, which are proportional to the square beamcurrent, and the calculated aberration erros. The geometrical spotsize itself is eliminated in these calculations.

The marker edge, the spot size and the beam current depend on the aberration disc.

The spot-setting software is, like the alignment, divided into sections according to the time-dependence of the parameters. First, a table of the demagnification factos and the corresponding zoom lens excitations is constructed; this requires 1 to 2 hours, but has to be performed only during routine maintenance. This table is extended to include the gun crossover size and the alignment data to make a table of spot sizes; this extension follows the implementation of a new cathode or the restart of an old one and takes typically about 10 minutes. Finally, setting the required spot contains only the proper choice from the spot size table followed by a calibration for focussing and stigmation and can be done within 1 minute. Up to 16 calibrated spots can be stored in a table from which the writing job can be set the correct spots within 2 seconds.

As an example of the results we have obtained with this software, the request "set spot diameter 50 nm" was issued; using a machine independent spot size measurement, to be described, the resulting spot size was 48 nm.

During the measurements earlier results about the required vacuum conditions and crystal purity were confirmed. Facetting of the crystal can be seen after 500 hr. at a pressure <2.10E-7 torr. In contrast after 1000 hr. at 2.10E-8 torr and the same temperature 1500°C the facetting is much less pronounced.

But even with the proper vacuum conditions, non volatile impurities remain at the surface during the evaporation that can cluster on the apex of the cone.

The way of mounting the crystal is less important for stability, high brightness and long life compared to the adjustment of the tip in the sehnelt assembly, careful temperature treatment, state of the wehnelt gap (e.g. burrs), deposition of evaporated material on the wehnelt, flash overs, state of the emitting area, cleanliness of the assembly etc.

Under a variety of circumstances the software set up the column properly. Even with very old cathodes (> 3 months) the machine was able to meet the acceptance specifications although at lower brightness (Br = 25 A/V.cm².ster at 50 kV).

Typical values for reduced brightness of 40-15 can be maintained for at least one month just by the fact that the tip is never forced to a higher performance than needed for the writing job. In principle, after inserting a new filament, the software calibrates the machine, sets a predefined spot or current and starts a writing job on customers request all automatically.

The convenience of this software has enhanced the turn around and up-time and generally the fitness for use.

## Claims

1. Charged particle beam apparatus provided with a particle source, a charged particle optical system, an object carrier and current measuring means, characterized in that the apparatus is provided with means to obtain measuring data obtainable from the apparatus and means to calculate control signals from these data to be used for setting the feeding of relevant charged particle optical elements of the apparatus.

2. Charged particle beam apparatus as claimed in Claim 1, characterized in that a beam deflector is dedicated for scanning the particle beam over a beamstop and current measuring means are dedicated to measure the current transpassing the beam stop.

3. Charged particle beam as claimed in Claim 1 or 2, characterized in that in a signal proces unit a cathode surface emission distribution is calculated from a scanning dependent current measuring.

4. Charged particle apparatus as claimed in Claim 1, 2 or 3, characterized in that in a signal process unit a value for spot demagnification is calculated from geometrical and or optical properties of the apparatus.

5. Charged particle beam apparatus as claimed in any one of the preceeding claims, characterized in that inhomogeneity in the cathode emission distribution is used for optimalization of the beam setting.

**FIG.1**

**FIG. 2**

**FIG. 3**

**FIG. 4**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 168 064 (TOSHIBA) <br> * Figures 11,12; page 12, line 8 - page 15, line 10 * <br> --- | 1-3,5 | H 01 J 37/304 <br> H 01 J 37/26 |
| X | FR-A-2 514 151 (THOMSON CSF) <br> * Figures 6,11; claims 1,14 * <br> --- | 1-3,5 | |
| X | EP-A-0 131 699 (IBM) <br> * Figure 1; claim 1 * <br> ----- | 1,2 | |

| TECHNICAL FIELDS SEARCHED (Int. Cl.4) |
|---|
| H 01 J 37/00 |

The present search report has been drawn up for all claims

| Place of search | Date of completion of the search | Examiner |
|---|---|---|
| THE HAGUE | 08-11-1988 | SCHAUB G.G. |

EPO FORM 1503 03.82 (P0401)